# EUROPEAN PATENT SPECIFICATION

(11) **EP 1 846 518 B1**
(45) Date of publication and mention of the grant of the patent: **02.09.2009**
(21) Application number: 05854245.7
(22) Date of filing: 15.12.2005
(51) Int. Cl.: C09D 11/00

(54) **SILVER-CONTAINING INKJET INK**
SILBERHALTIGE TINTENSTRAHLTINTE
ENCRE D'IMPRESSION PAR JET D'ENCRE CONTENANT DE L'ARGENT

(30) Priority: 16.12.2004 US 636610 P
(43) Date of publication of application: 24.10.2007
(73) Proprietor: E.I. DU PONT DE NEMOURS AND COMPANY, Wilmington, DE 19898 (US)
(72) Inventor: REINARTZ, Nicole, M., Wilmington, Delaware 19810 (US)
(74) Representative: Heinemann, Monica
(86) International application number: PCT/US2005/045482
(87) International publication number: WO 2006/066033

(56) References cited:
- EP-A- 1 548 073
- WO-A-03/032084
- WO-A-03/106573
- US-A1- 2003 108 664

## Description

### BACKGROUND OF THE INVENTION

This invention pertains to an ink set comprising said silver ink and an ink with reducing agent to reduce the silver in the silver ink. The invention further pertains to an inkjet printing method for printing with the inventive ink set to create metallic silver images (or patterns). The printed silver patterns can be used, for example, in electronics and decorative applications.

Inkjet printing is a non-impact printing process in which droplets of ink are deposited on a substrate to form the desired image. The droplets are ejected from a printhead in response to digital signals generated by a microprocessor. Inkjet printing can be especially advantageous for making unique prints or small lots because, as a digital technology, images can be easily changed or varied.

There has been much interest recently in using inkjet printing techniques in electronics manufacture and in particular to print conductive metal patterns. For example, WO04/068389 and WO04/106585 disclose methods for forming a conductive metal region on a substrate involving inkjet printing.

In other art, namely US4266229 and US5091003, inkjet ink comprising silver nitrate is disclosed. However, the silver content in the silver ink is low and the ink is not used in a way that generates a conductive metal pattern.

In addition, US5501150 discloses the use of inkjet printing to deposit a silver image in the manufacture of lithographic printing plates.

All of the above publications are incorporated by reference herein for all purposes as if fully set forth.

There is a need in the art for inkjet inks and inkjet printing methods that can provide conductive patterns.

### SUMMARY OF THE INVENTION

The present invention pertains to an inkjet ink set comprising a first inkjet ink that is an inkjet ink, and a second inkjet ink comprising an aqueous vehicle having dissolved therein a silver salt and an amine sensitizer for the silver salt, wherein the amine sensitizer is a compound containing at least one amine group, and wherein the ink contains at least about 1% by weight silver ion (Ag¹⁺) based on the total weight of the ink, and a second inkjet ink that comprises a reducing agent is capable of reducing silver salt to silver metal.

Preferably the ink is substantially clear and colorless.

In a further aspect of the present invention, there is provided a method for ink jet printing a silver pattern or image onto a substrate, comprising the steps of:
(a) providing an ink jet printer that is responsive to digital data signals;
(b) loading the printer with a substrate to be printed;
(c) loading the printer with an inkjet ink set as set forth above and described in detail below;
(d) ejecting the inkjet ink onto the substrate in response to the digital data signals to print an image or pattern of the silver salt on the substrate; and
(e) concurrently with or subsequent to the ejecting step, effecting reduction of at least a portion of the silver salt in the image or pattern on the substrate to silver metal to produce the silver image or pattern.

By "effecting reduction of the silver salt" is meant reducing silver ion (e.g., Ag¹⁺) to silver metal (Ag⁰).

The reduction is effected through the use of the second inkjet ink and inkjet ink set as set forth above and described in detail below, wherein the printer is loaded with the inkjet ink set, and wherein the reduction is effected at least in part by the reducing agent in the second inkjet ink.

Further, it is preferred that at least a portion of the silver pattern or image is electrically conductive, and that substantially all of the silver salt in the image or pattern in reduced to silver metal.

In still another aspect of the present invention, there are provided articles manufactured using the ink sets and processes of the present invention, such as flat panel displays, automobile windshields, circuit boards, solar cells and other printed electronics such as radio frequency identification (RFID) tags, smart cards, smart packaging, electronic paper, disposable displays and membrane key pads.

These and other features and advantages of the present invention will be more readily understood by those of ordinary skill in the art from a reading of the following detailed description. It is to be appreciated that certain features of the invention which are, for clarity, described above and below in the context of separate embodiments, may also be provided in combination in a single embodiment. Conversely, various features of the invention that are, for brevity, described in the context of a single embodiment, may also be provided separately or in any subcombination. In addition, references in the singular may also include the plural (for example, "a" and "an" may refer to one, or one or more) unless the context specifically states otherwise.

### DETAILED DESCRIPTION OF THE PREFERRED EMBODIMENTS

### Silver Ink

As indicated above, silver inks suitable for use in the present invention generally comprise an aqueous vehicle having dissolved therein a silver salt (soluble silver salt) and an amine sensitizer for the silver salt. The silver salt dissociates in solution to form silver ions, and may complex with the amine sensitizer. In other words, a complex of the silver salt and amine sensitizer, and/or such components in their individual forms, in solution in the aqueous vehicle is within the scope of the present invention even though the silver salt and amine sensitizer may be indicated as separate components.

While the inks are referred to as silver inks, this is done so because of the silver content. Preferably these inks are substantially clear and colorless.

### Soluble Silver Salts

Silver salts include, but are not limited to, silver nitrate, silver nitrite, silver carbonate, silver sulfate, silver phosphate, silver chlorate, silver perchlorate, silver oxide, silver fluoride, silver chloride, silver iodide, and silver tetrafluoroborate; as well as the silver salts of organic acids, including silver acetate, silver trifluoroacetate, silver pentafluoropropionate, silver lactate, silver citrate, silver oxalate, silver tosylate, silver methanesulfonate, and silver triflate.

Preferred silver salts include silver nitrate, silver carbonate, silver sulfate, silver acetate, silver trifluoroacetate, silver pentafluoropropionate, silver tosylate and silver methanesulfonate. Especially preferred is silver nitrate, which is soluble at levels of 2.34 grams per gram of water.

Generally, it is advantageous to maximize the loading of silver in the silver ink so that, when printed, thicker, more conductive silver films can be formed with fewer passes. Silver inks should contain at least about 1 wt% silver ion (Ag¹⁺), more preferably at least about 5 wt% silver ion, and may contain up to about 50 wt% silver ion. Preferably the inks contain from about 10 wt% to about 40 wt% silver ion, based on the total weight of the ink. In one embodiment, silver loadings of from about 25 wt% to about 35 wt% silver ion were found to give a good balance between printability of the silver ink and conductivity of the printed pattern.

### Amine Sensitizers

Certain compounds, referred to herein as amine sensitizing agents (or "amine sensitizers"), increase the susceptibility of silver ion to reduction. Many of these, when present in the silver ink, can also increase solubility of silver salts in the vehicle.

Amine sensitizers include organic nitrogen bases such as primary, secondary and tertiary aliphatic and aromatic amines, and nitrogen heterocyles such as pyridine and bipyridine. Amines can be monofunctional amines and/or multifunctional amines such as diamines, triamines, tetramines and so forth.

Preferred amine sensitizers for a particular silver salt are those that can be combined with the silver salt to produce a substantially clear, colorless solution with substantially no precipitate. This can readily be determined by those of ordinary skill in the art with minimal experimentation via a scouting procedure such as set forth hereinafter in the "Examples" section.

Preferred amine sensitizers for a particular silver salt are also those that, when combined with the silver salt and are then reduced to deposit the silver on a substrate, result in a silver deposit that is conductive and, in partcular, that exhibits a resistance of less than about 10 ohms (and preferably substantially no resistance). This again can readily be determined by those of ordinary skill in the art with minimal experimentation via a "spot test" such as set forth hereinafter in the "Examples" section.

Specifically excluded from amine sensitizers are ammonia and ammonium compounds. The combination of ammonia and silver salts may lead to formation of a touch-sensitive explosive decomposition product, silver nitride (Ag₃N), as reported by J. K. Luchs in Photographic Science and Engineering, 1966, volume 10, pages 334-337, and should be avoided.

Preferred amine sensitizers include organic compounds containing one or more amine groups, such as those of the formula: 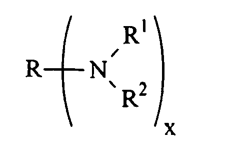 wherein R is a first organic group having x amino groups attached thereto, R¹ is H or a second organic group, R² is H or a third organic group, and x is the number of amino groups attached to the first organic group. More preferred are those compounds wherein wherein R is an organic group having 1-3 carbon atoms, R¹ is H or methyl, R² is H or methyl, and x is an integer of from 1 to 3. Particularly preferred are those compounds wherein R is an alkyl or alkylene group of 1-3 carbon atoms, R¹ is H or methyl, R² is H or methyl, and x is 1 or 2. Especially preferred is methylamine, ethylamine, n-propylamine, *iso*-propylamine and ethylenediamine, and most preferred is methylamine, ethylamine, n-propylamine and *iso*-propylamine.

Amine sensitizers can be usefully employed at any amount, but are preferably present at levels of at least about 1% by weight based on the total weight of ink. More preferably, the amine sensitizers are present at a ratio of about two or more moles of amino groups per mole of silver. For monoamines, such as the primary aliphatic monoamines, this means about two or more moles of the monoamine compound per mole of silver. For diamines, this means about one or more moles of diamine compound per mole of silver.

Sensitized aqueous silver inks tend to be susceptible to air oxidation on prolonged storage and should be tightly sealed to minimize decomposition.

### Reducing Agent and Reducing Ink

A reducing agent, as prescribed herein, is capable of reducing silver ion (Ag⁺) to silver metal (Ag⁰). Reducing agents include, but are not limited to, sodium borohydride; dimethylamineborane; hydrazine; hydroxylamine; hypophosphorous acid; carbon monoxide gas; hydrogen gas; hydroquinone; polyols such as ethylene glycol; citric acid and its salts; ascorbic acid and its salts; N,N-dimethylformamide; formic acid and glyoxylic acid; formaldehyde, glyoxal, glucose, glyceraldehyde and all other molecules containing at least one aldehyde functionality; and cyclic aldehyde oligomers such as trioxane, glycolaldehyde dimer and glyoxal trimeric dihydrate.

The reducing agent is formulated into an inkjet ink ("reducing ink") and jetted along with the silver ink onto the substrate. Generally, the reducing agent will be formulated with a vehicle to be jettable, but in some cases it may be possible to directly jet the pure reducing agent. The term reducing ink is understood to mean the reducing agent in jettable form, with or without additional additives or vehicle. Preferred reducing agents include formaldehyde, glyoxal, formic acid, glyceraldehyde, and glycolaldehyde dimer. Reducing inks formed with these reducing agents are storage stable and physically benign (not explosive, corrosive or exceedingly reactive). These low molecular weight aldehydes are not only effective reducing agents but are in turn oxidized to low molecular weight, volatile byproducts (including CO₂ gas) which evaporate readily from the printed silver film leaving little organic contamination. Other reducing agents (glucose, for example) can leave residue that is believed to diminish the silver film's conductivity.

### Aqueous Vehicle

The term "aqueous vehicle" refers to water or a mixture of water and at least one water-soluble organic solvent (co-solvent). Selection of a suitable mixture depends on requirements of the specific application, such as desired surface tension and viscosity, drying time of the ink, and the type of substrate onto which the ink will be printed. Representative examples of water-soluble organic solvents that may be selected are disclosed in US5085698 (the disclosure of which is incorporated by reference herein for all purposes as if fully set forth).

Silver solutions, especially silver solutions with sensitizer, can be unstable in the presence of many organic species commonly employed as additives and co-solvents in inkjet formulations. Care must be taken in the selection formulation ingredients to ensure suitable shelf life. Various co-solvents and additives are provided in the examples herein after.

### Other Ingredients

In addition to the silver salt, sensitizer, reducing agent and vehicle mentioned and described above, other ingredients, as are well known to those of ordinary skill in the relevant art, can be added to optimize performance. Such other ingredients may be formulated into the inkjet ink, to the extent that such other ingredients do not interfere with the stability and jettablity of the ink, which may be readily determined by routine experimentation.

### Ink Properties

Drop velocity, separation length of the droplets, drop size and stream stability are greatly affected by the surface tension and the viscosity of the ink. Ink jet inks typically have a surface tension in the range of about 20 dyne/cm to about 70 dyne/cm, and preferably in the range of from about 20 dyne/cm to about 50 dyne/cm, at 25°C. Viscosity can be as high as 30 cps at 25°C, but is typically somewhat lower.

The physical properties of the ink are adjusted to the ejecting conditions and printhead design. Although not restricted to any particular viscosity range or printhead, the application contemplated by this invention will generally require lower viscosity ink. Thus the viscosity (at 25°C) of the inks can be less than about 7 cps; less than about 5 cps, and even less than about 3.5 cps.

The inks should have excellent storage stability for long periods so as not clog to a significant extent in an ink jet apparatus.

### Ink Sets

An ink set in accordance with the present invention comprises two inks, the first ink being a silver ink as described above, and the second ink being a reducing ink as also described above.

### Printing Method

The ink sets of the present invention can be utilized by printing with any inkjet printer.

The reduction is effected through the use of the second (reducing) ink and ink set as described above. Application of silver ink and reducing ink can be done in any order. In other words, the silver ink can be underprinted and/or overprinted with the reducing ink. The relative ratios of silver ink and reducing ink as applied to a substrate are preferably such as to effective substantially complete reduction of the silver ions in the silver ink.

In any embodiment of the present method, a plurality of layers of ink, either silver ink or reducer ink, can be applied. A (one) layer refers to about 100% area coverage of an ink on a given region of the substrate. Thus, two layers is about 200% coverage, three layers is about 300% and so forth. The number of layers of reducing ink may be less than, equal to or greater than the number of layers of silver ink.

When printing multiple layers of ink, it may be desirable to allow a presiding layer to dry before applying the next layer.

Preferably, all or most of the silver ions in the pattern of silver salt are reduced to silver metal to form a pattern of silver metal. Preferably, at least a portion of the pattern of silver metal is electrically conductive.

### Substrate and Articles

The substrate can be any desired substrate including glass; silicon; ceramics; papers of all types, including plain paper, ink jet-ready specialty coated papers (microporous and polymer-coated), synthetic papers such as Teslin® (PPG Corporation), magazine-type glossy papers and calendered papers; cardboard; transparencies; plastics of all types; architectural materials such as wallpaper; and fabrics and textiles.

The present invention may be used, for example, to make digitally patterned, electrically conductive printed metal articles. Conductive metal patterns include, for example, electrical contacts, interconnects, electrodes and wires used in devices such as, but not limited to, transistors, capacitors, inductors, resistors and transducers. The present invention can be useful for rapid fabrication of test circuits and prototypes of electronic devices.

In one aspect, the substrate can be a glass substrate and the printed article can be, for example, a flat panel display or automobile windshield.

In another aspect, the substrate can be a silicon substrate and the printed article can be, for example, a circuit board or solar cell.

In yet another aspect, the substrate can be a paper, plastic or cardboard substrate and the printed article can be, for example, an radiofrequency identification (RFID) tag, smart card, smart packaging, electronic paper, disposable display, membrane key pad, or similar printed electronic.

Various applications include batteries; fuel cells; solar cells; membrane key pads; biological, mechanical, and chemical sensors, including those applied to "smart" packaging or "smart" textiles, which allow the object to respond to environmental conditions; and all types of flat panel displays, including plasma displays, liquid crystal displays (LCDs), electroluminescent displays containing light-emitting polymers or small organic molecules, "electronic paper" displays on flexible polymer substrates, and low-cost disposable displays. The invention may also be used to repair defects in conventionally deposited conductive metal patterns and for decorative applications when a reflective, mirror-like silver image is desired.

The present invention is advantageous in that conductive patterns can be formed at low temperatures, allowing a wide choice of substrate. The present invention is also advantageous in that it does not require suspension of heavy metal particles.

### EXAMPLES

Ingredient amounts are in parts by weight, unless otherwise stated. Water was purified by deionization prior to use. Viscosity was measured by Brookfield rotational viscometry at about 25°C. Surface tension was measured with a Kreuss tensiometer model K12 using the plate method. Molarity (M) of silver means moles of silver ion per liter of ink, and weight percent (wt %) silver means weight of silver ion (or atomic silver) per total weight of ink.

### Scouting Sensitizers

Various amines were scouted for compatibility with aqueous solutions of silver nitrate and for their ability to promote (sensitize) the reduction of silver nitrate by formaldehyde (formaldehyde reduces silver nitrate very slowly without sensitizer present). The amines were added to aqueous solutions of silver nitrate to give inks containing 3 molar equivalents of amine per mole of silver and ranging from 1.5 to 3.5 molar in silver. The appearance of the solutions (precipitate formation, color, etc) was observed over time.

"Spot tests" were performed to assess the ability of the amines to promote reduction of silver nitrate to silver metal by formaldehyde. The "spot test" procedure involved putting a 20 microliter drop of formaldehyde reducing ink on top of a 20 microliter drop of silver-amine solution on an overhead transparency sheet. The droplet combinations were allowed to dry at room temperature for 14 to 20 hours. The electrical resistance across the dried spots was measured with a multimeter. Lower resistance means better conductivity and thus more effective reduction of silver ion to silver metal. Compatibility and Conductivity were evaluated according to the following scale:

| | |
|---|---|
| Compatibility rating: | 1 = clear, colorless solution with no precipitate (best); |
| | 2 = silver mirror forms on vial |
| | 3 = silver precipitate forms |
| | 4 = black or white precipitate or gel forms (worst) |
| Conductivity rating: | 1= (Excellent) 0-10 Ohms (Ω) |
| | 2= (Good) 10-1000 Ohms |
| | 3= (Poor) 1000-1000000 Ohms |
| | 4= (Not conductive) >1000000 Ohms |
| | --- indicates no test performed |

| Name | Compatibility Rating | Conductivity Rating |
|---|---|---|
| Methylamine, 40 wt% aqueous | 1 | 1 |
| Ethylamine, 70 wt% aqueous | 1 | 1 |
| Isopropylamine | 1 | 1 |
| Ethylenediamine (EDA) | 1 | 2 |
| Dimethylamine, 40 wt% aq. | 2 | 1 |
| Trimethylamine, 40 wt% aq. | 2 | 1 |
| Triethylamine | 2 | 2 |
| DMEDA | 2 | 1 |
| TMEDA | 3 | 1 |
| Ethanolamine | 3 | 2 |
| *tert*-Butylamine | 4 | -- |
| Cyclohexylamine | 4 | -- |
| Benzylamine | 4 | -- |
| Aniline | 4 | 3 |
| N,N-Dimethylaniline | 4 | -- |
| Pyridine | 4 | -- |
| Bipyridine | 4 | -- |
| 1,2-Dianilinoethane | 4 | -- |

The group of amines: methylamine, ethylamine and isopropylamine, gave clear colorless solutions indicating they would be compatible in an aqueous silver ink. They also promoted reduction of silver nitrate by formaldehyde and therefore are preferred sensitizers for the silver ink. Ethylenediamine gave a clear colorless solution but, in this test, did not give as conductive a silver spot on reduction by formaldehyde.

The group of amines: *tert*-butylamine, cyclohexylamine, benzylamine, aniline, N,N-dimethylaniline, pyridine, 2,2'-dipyridyl (bipyridine), and 1,2-dianilinoethane caused a black or white precipitate to form when added to an aqueous silver solution. The ability of these amines to promote reduction of silver nitrate by formaldehyde was not tested due to poor compatibility with the scouting formulation. They may, however, be useful in other formulations.

The group of amines: trimethylamine, triethylamine, dimethylamine, dimethylethylenediamine, tetramethylethylenediamine and ethanolamine reacted with aqueous silver nitrate to form a silver precipitate or mirror on the bottom of the sample vial. These amines all seem to promote reduction of silver nitrate by formaldehyde.

### Scouting of Potential Formulation Ingredients

Various potential formulation ingredients were scouted as cosolvents/additives for aqueous silver nitrate solution and aqueous silver nitrate solution with methylamine sensitizer. The aqueous silver solution was 5 molar silver nitrate in water. The sensitized aqueous silver solution was 3.4 molar in silver nitrate and 10.2 molar in methylamine (MeNH₂).

The test procedure involved mixing the test ingredient/additive with the silver solution in a small vial. Surfactant additives were tested at ca. 1% by weight, and all other ingredients were tested at 25% by weight. The vials were capped and shaken to mix the contents. The appearance of the solutions (precipitate formation, color, etc) was observed over time. The formulation was evaluated according to the following scale

| | |
|---|---|
| Formulation Rating: | 1 = no or very slight precipitate (best); |
| | 2 = small amount of precipitate, |
| | 3 = moderate amount of precipitate; |
| | 4 = large amount of precipitate (worst) |

A rating of 1 or 2 indicated good compatibility. A rating of 3 or 4 indicated poor compatibility. However, ingredients performing poorly in this test might be useful under different conditions.

| Surfactant Additive | Aqueous Silver Nitrate with MeNH₂ | Aqueous Silver Nitrate (no amine) |
|---|---|---|
| Aerosol® OT | 1 | 2 |
| Silwet® L77 | 2 | 4 |
| Surfynol® 465 | 2 | 4 |
| Zonyl® FS-62* | 1 | 3 |
| Byk® 348 | 3 | 4 |

| | | |
|---|---|---|
| *Solution turned yellow-orange | | |

Surfynol® 465 (ethoxylated acetylene diol, Air Products Corporation); Aerosol® OT (dialkylsulfosuccinate, Cytec Corporation); Zonyl® FS-62 (fluoro-surfactant, E. I. Du-Pont Corporation,), Silwet® L77 (silicone, Witco Chemical) and Byk® 348 (silicone, Byk Chemie) are surfactants.

| Ingredient | Aqueous Silver with MeNH₂ | Aqueous Silver (no amine) |
|---|---|---|
| Ethylene glycol | 4 | 1 |
| 1,2-Hexanediol | 4 | 1 |
| Glycerol | 4 | 1 |
| Isopropanol | 3 | 1 |
| Diethylene glycol | 3 | 1 |
| Dipropylene glycol | 3 | 1 |
| Ethylene glycol mono-*n*-butyl ether | 3 | 1 |
| Diethylene glycol mono-*n*-Butyl ether | 3 | 1 |
| Propylene glycol methyl ether acetate | 3 | 1 |
| 1-methyl-2-pyrrolidone | 3 | 1 |
| Sulfolane | 3 | 1 |
| Glycerol ethoxylate, MW=1000 | 3 | 4 |
| Dipropylene glycol dimethyl ether | 2 | 1 |
| Tetra(ethylene glycol) dimethyl ether | 2 | 1 |
| Methanol | 1 | 1 |
| 2-pyrrolidinone | 1 | 1 |
| Trimethylolpropane* | 1 | 2 |
| Urea | 1 | 4 |
| *2-ethyl-2-(hydroxymethyl)-1,3-propanediol | | |

### Scouting of Reducing Agents

To scout potential reducing agents for reducing inks, spot tests, as described previously, were performed to assess agents for reducing silver ion to silver metal.

Reducing agents were tested as aqueous solutions or neat liquids. The silver amine solutions were similar to those described previously. The molar ratio of silver ion to reducing agent was generally either 1:1 or 2:1.

Conductivity was evaluated according to the 1-4 scale previously described, with one additional category added. A rating of 1-b means silver metal forms, and it is assumed to be conductive, but resistance was not measured.

| Reducing Agent | Aqueous Silver Nitrate with MeNH₂ | Aqueous Silver Nitrate |
|---|---|---|
| Sodium borohydride | --- | 1-b |
| Hydroquinone | --- | 1-b |
| Hydroxylamine, 50 wt% aqueous | 1 | 1 |
| L-Ascorbic Acid | 1 | 3 |
| Hydrogen gas | 3 | --- |
| Formaldehyde, 37 wt% aqueous | 1 | 4 |
| Formic Acid | 1 | --- |
| Sodium formate | 3 | --- |
| Trioxane | 4 | --- |
| Glucose | 1 | 4 |
| Glyoxal, 40 wt% aqueous | 1 | --- |
| Glyoxylic acid, 50 wt% aqueous | 3 | --- |
| DL-glyceraldehyde | 1 | 4 |
| Glycoaldehyde dimmer | 1 | --- |
| Glyoxal trimeric dihydrate | 1 | --- |
| Dimethoxymethane | 3 | --- |
| Dimethoxyacetaldehyde, 60 wt% aqueous | 3 | --- |
| Malonaldehyde bis(dimethyl acetal) | 3 | --- |
| Glucose + Ammonium hydroxide | --- | 1-b |
| Formic acid + Methylamine, 40 wt% aqueous | 1 | 1 |
| DL-glyceraldehyde + Methylamine, 40 wt% aqueous | 1 | 1 |
| Formaldehyde, 37 wt% aqueous + Methylamine, 40 wt% aqueous | 2 | 4 |
| Formaldehyde, 37 wt% aqueous + Ammonium Hydroxide, 28 wt% aqueous | 4 | 4 |
| Tetramethylethylenediamine (TMEDA) | 1 | 1 |
| Tetraethylethylenediamine (TEEDA) | --- | 2 |
| Dimethylethylenediamine (DMEDA) | 2 | 3 |
| Ethanolamine | 3 | 3 |
| Dimethylamine, 40 wt% aqueous | 3 | 3 |
| Trimethylamine, 40 wt% aqueous | 3 | 3 |
| Triethylamine | 3 | 3 |

These tests were only used to help prioritize evaluation of ingredients. An adverse result in this test may not indicate an ingredient is unsuitable under all conditions. Hydrogen gas, for example, reacted with the surface of the ink droplet to form a crust of silver metal which then prevented further hydrogen gas from reaching the interior of the ink droplet and reducing the rest of the silver. However, under proper conditions, hydrogen gas can reduce the silver methylamine ink.

### Scouting of Various Silver Salts for the Silver Ink

A series of methylamine-sensitized silver inks, 3.4 M in silver and 10.2 M in methylamine, was prepared with the following silver salts in place of silver nitrate. Spot tests were run using glucose and formaldehyde inks as the reducing inks. The salts tested were all comparable in performance to silver nitrate. All of the silver salts are more soluble in aqueous methylamine than in pure water.

| Silver salt in Silver Ink | Conductivity rating, Glucose reducer | Conductivity Rating, Formaldehyde reducer |
|---|---|---|
| Silver Carbonate | 1 | 1 |
| Silver Sulfate | 1 | 1 |
| Silver Acetate | 1 | 1 |
| Silver Tosylate | 1 | 1 |
| Silver Methanesulfonate | 1 | 1 |
| Silver Trifluoroacetate | 1 | 1 |
| Silver Pentafluoropropionate | 1 | 1 |

### Preparation of Silver Inks

A series of silver inks containing methylamine sensitizer (Inks 1A-1F), ethylamine sensitizer (Inks 2A-2C), or isopropylamine sensitizer (Ink 3) was prepared according to the recipes in the following tables.

| Silver Ink Formulation | 1A | 1B | 1C | 1D | 1E | 1F |
|---|---|---|---|---|---|---|
| Silver Nitrate | 20.0 | 20.0 | 20.0 | 20.0 | 20.0 | 20.0 |
| Methylamine, 40 wt% aq. | 27.4 | 18.3 | 27.4 | 19.2 | 27.4 | 27.4 |
| Aerosol® OT | 0.096 | 0.077 | 0.116 | 0.098 | 0.100 | 0.096 |
| Water | ---- | ---- | ---- | 2.5 | ---- | 2.26 |
| Methanol | ---- | ---- | 11.8 | ---- | ---- | ---- |
| 2-Pyrrolidone | ---- | ---- | ---- | 7.5 | 2.38 | ---- |
| Urea | ---- | ---- | ---- | ---- | ---- | 0.12 |

| Properties | | | | | | |
|---|---|---|---|---|---|---|
| Viscosity (cps) | 2.9 | 3.0 | 2.5 | 4.2 | 3.4 | 3.2 |
| Surface Tension (dyne/cm) | 30.7 | 33.7 | 22.3 | 33.1 | 38.0 | 35.3 |
| Density (g/mL) | 1.36 | 1.46 | 1.19 | 1.35 | 1.33 | 1.34 |
| pH | 14 | 14 | 14 | 14 | 14 | 14 |
| Silver Concentration (wt%) | 26.7 | 33.1 | 21.4 | 25.8 | 25.4 | 25.4 |
| Silver Concentration (M) | 3.4 | 4.2 | 2.7 | 3.2 | 3.2 | 3.2 |
| Molar ratio Amine/Silver | 3.0 | 2.0 | 3.0 | 2.1 | 3.0 | 3.0 |

| Silver Ink Formulation | 2A | 2B | 2C | 3 |
|---|---|---|---|---|
| Silver Nitrate | 20.0 | 20.0 | 20.0 | 20.0 |
| Ethylamine, 70 wt% aq. | 22.7 | 15.9 | 16.1 | ---- |
| Isopropylamine | ---- | ---- | ---- | 20.9 |
| Water | ---- | ---- | ---- | 8.94 |
| Aerosol® OT | ---- | ---- | 0.041 | ---- |

| Properties | | | | |
|---|---|---|---|---|
| Viscosity (cps) | 5.32 | 9.84 | 11.1 | 8.26 |
| Surface Tension (dyne/cm) | 32.0 | 38.6 | 35.0 | 26.4 |
| Density (g/mL) | 1.26 | 1.52 | 1.56 | 1.26 |
| Silver Concentration (wt%) | 29.7 | 35.4 | 35.1 | 25.5 |
| Silver Concentration (M) | 3.5 | 5.1 | 5.1 | 3.0 |
| Molar ratio Amine/Silver | 3.0 | 2.1 | 2.1 | 3.0 |

### Preparation of Ink Series 1 and 2

In a fume hood, a solution of commercially available aqueous amine (40 wt% aqueous methylamine or 70 wt% aqueous ethylamine) was added to a glass vessel and cooled in an ice bath. With the solution vigorously stirred, solid silver nitrate was then added to the cooled aqueous amine in small portions with ten minutes between addition of each portion. Immediately after each addition of silver nitrate, a dark brown precipitate formed, but after stirring for several minutes, the precipitate redissolved to give a gray solution.

After addition of all the silver nitrate, the vessel was removed from the ice bath and allowed to warm to room temperature over about thirty minutes. The solution became almost colorless and was mainly free of precipitate. Other ink components were then added as specified in the preceding formulation tables, and the solution was filtered through a 1 micron syringe filter. A small number of gray particles were removed by the filter. The final solution was kept tightly sealed and protected from light when not in use.

### Preparation of Ink 3

This ink was prepared in a manner similar to the series 1 and 2 inks, except that neat isopropylamine was used instead of an aqueous solution. When each portion of crystalline silver nitrate was added to the reaction vessel, the solid initially dissolved, but then a new white solid precipitated to form a thick slurry. The water was then added until the overall composition of liquid added to the reaction vessel was 70 wt% isopropylamine, 30 wt% water. After stirring for several minutes at 0°C, the white precipitate dissolved to give a completely clear, colorless solution.

The ice bath was removed and the solution warmed to room temperature over about 30 minutes. The colorless solution was filtered through a 1 micron syringe filter, although no particles were seen to be removed. The final solution was kept tightly sealed when not in use and was found to remain clear and colorless after >1 month of storage under ambient light.

| Silver Ink Formulation | 4A (Comparative) | 4B (Comparative) |
|---|---|---|
| Silver Nitrate | 84.9 | 18.7 |
| Ethylene glycol | ---- | 13.5 |
| Water | 81.1 | 17.7 |
| Aerosol® OT | 0.330 | 0.100 |

| Properties | | |
|---|---|---|
| Viscosity (cps) | 2.28 | 3.59 |
| Surface Tension (dyne/cm) | 26.1 | 26.3 |
| Density (g/mL) | 1.66 | 1.49 |
| pH | 4 | 4 |
| Silver Concentration (wt%) | 32.5 | 23.7 |
| Silver Concentration (M) | 5.0 | 3.3 |

### Preparation of Inks 4A and 4B - Comparative

Crystalline silver nitrate was weighed into a flask and dissolved in water to give a clear, colorless 5 M solution. The remaining ingredients were then added as specified in the preceding formulation tables. The solution was filtered through a 1 µm syringe filter before printing.

### Preparation of Reducing Inks

Reducing inks were prepared according to the formulas in the following tables.
Ingredients were mixed together and filtered through a 1 µm syringe filter.

| Reducing Ink Formulation | 5A | 5B | 5C | 5D | 5E |
|---|---|---|---|---|---|
| Formaldehyde, 37 wt% aq. | 31 | 17.0 | 7.0 | 24.4 | 15.7 |
| Water | 171 | 83.0 | 23.5 | 75.6 | 35.6 |
| Surfynol® 465 | 0.808 | 0.400 | 0.123 | 0.400 | 0.205 |

| Properties | | | | | |
|---|---|---|---|---|---|
| Viscosity (cps) | 1.20 | 1.19 | 1.25 | 1.26 | 1.36 |
| Surface Tension (dyne/cm) | 30.1 | 29.0 | 30.6 | 30.6 | 28.9 |
| Density (g/mL) | 1.01 | 1.00 | 1.01 | 1.01 | 1.02 |
| PH | 5 | 4.5 | 4.5 | 4.5 | 5 |
| Formaldehyde Conc (wt%) | 5.7 | 6.3 | 8.5 | 9.0 | 11.3 |
| Formaldehyde Conc. (M) | 1.9 | 2.1 | 2.9 | 3.0 | 3.8 |

| Reducing Ink Formulation | 5F | 5G | 5H | 5I | 5J |
|---|---|---|---|---|---|
| Formaldehyde, 37 wt% aq | 25 | 3.8 | 15.7 | 3.8 | 7.7 |
| Water | ---- | 21.2 | 35.6 | 21.2 | 28.6 |
| 1,2-Hexanediol | ---- | ---- | ---- | ---- | 2 |
| Glycerol | ---- | ---- | ---- | ---- | 7.5 |
| Ethylene glycol | ---- | ---- | ---- | ---- | 2.5 |
| 2-Pyrrolidone | ---- | ---- | ---- | ---- | 1.5 |
| Aerosol® OT | 0.025 | 0.050 | 0.051 | ---- | ---- |
| Zonyl® FS-62 | ---- | ---- | ---- | 0.050 | ---- |
| Surfynol® 465 | ---- | ---- | ---- | ---- | 0.200 |

| Properties | | | | | |
|---|---|---|---|---|---|
| Viscosity (cps) | 2.55 | 1.14 | 1.32 | 1.13 | 2.66 |
| Surface Tension (dyne/cm) | 33.8 | 25.8 | 26.4 | 18.7 | 31.2 |
| Density (g/mL) | 1.09 | 1.00 | 1.02 | 1.00 | 1.06 |
| PH | 4.5 | 5 | 5 | 5 | 4.5 |
| Formaldehyde Conc. (wt%) | 37 | 5.6 | 11.3 | 5.6 | 5.7 |
| Formaldehyde Conc. (M) | 12.3 | 1.9 | 3.8 | 1.9 | 2.0 |

| Reducing Ink Formulation | 6A | 6B | 6C | 7A | 7B | 8 |
|---|---|---|---|---|---|---|
| Glyoxal, 40 wt% aq | 27.9 | 27.9 | 13.9 | ---- | ---- | ---- |
| Glycolaldehyde dimer | ---- | ---- | ---- | 5.0 | 11.5 | ---- |
| DL-Glyceraldehyde | ---- | ---- | ---- | ---- | ---- | 8.7 |
| Water | 27.9 | 27.9 | 38.6 | 21.6 | 41.5 | 43.3 |
| Aerosol® OT | 0.056 | ---- | ---- | 0.011 | ---- | ---- |
| Surfynol® 465 | ---- | 0.223 | 0.20 | ---- | 0.20 | 0.20 |

| Properties | | | | | | |
|---|---|---|---|---|---|---|
| Viscosity (cps) | 2.07 | ---- | 1.36 | 1.55 | 1.71 | 1.54 |
| Surface Tension (dyne/cm) | 26.1 | ---- | 28.9 | 26.6 | 29.0 | 28.5 |
| Density (g/mL) | 1.11 | 1.11 | 1.05 | 1.05 | 1.06 | 1.04 |
| PH | 3 | 3 | 3 | 5 | 5 | 4 |
| Reducing Agent (wt%) | 20 | 20 | 10.6 | 18.8 | 21.7 | 16.7 |
| Reducing Agent (M) | 3.8 | 3.8 | 1.9 | 1.9 | 1.9 | 1.9 |

| Reducing Ink Formulation | 9 | 10 | 11A | 11B | 12 |
|---|---|---|---|---|---|
| Glucose | 17.3 | ---- | ---- | ---- | ---- |
| Formic acid | ---- | 4.4 | ---- | ---- | ---- |
| TMEDA | ---- | ---- | 14.5 | 10.6 | ---- |
| TEEDA | ---- | ---- | ---- | ---- | 14.5 |
| Water | 38.3 | 46.3 | 32.8 | 36.3 | 32.6 |
| Surfynol® 465 | 0.200 | 0.203 | 0.189 | 0.200 | 0.188 |

| Properties | | | | | |
|---|---|---|---|---|---|
| Viscosity (cps) | 2.85 | 1.08 | 5.25 | 3.36 | 5.08 |
| Surface Tension (dyne/cm) | 28.6 | 30.1 | 34.4 | 34.9 | 24.1 |
| Density (g/mL) | 1.11 | 1.01 | 0.955 | 0.963 | 0.960 |
| pH | 5 | 1.5 | ---- | 11 | ---- |
| Reducing Agent (wt%) | 31 | 8.6 | 30 | 23 | 31 |
| Reducing Agent (M) | 1.9 | 1.9 | 2.5 | 1.9 | 1.7 |

### Print Tests

Silver ink and reducing ink were jetted onto HP Premium Photo Glossy Film (C3836A), a microporous media coated with alumina and silica, using an Epson® Stylus® Color 3000 piezoelectric ink jet printer. The printer was modified so that inks could be fed from bottles through dampers into the print heads, instead of being loaded into cartridges. The "black" print head was primed with silver ink while reducing ink was loaded into the cyan channel of the "color" print head.

A test pattern consisting of a 2.5-inch square was drawn using the Macromedia Freehand MX graphics program. This pattern was assigned the color "100% black" in the program and printed at 1440 dpi. Silver ink 1A was jetted onto the paper, forming a colorless, wet pattern. The same test pattern was then reassigned to "100% cyan" in order to jet the reducing ink. The media was reloaded into the printer and the pattern printed again at 1440 dpi, resulting in deposition of reducing ink on top of silver ink. As soon as the inks came into contact with each other on the substrate, they reacted to deposit silver metal, and the printed pattern turned a dark brown or black color. The print was dried in a vacuum oven at 50°C for about fifteen minutes to evaporate ink vehicle from the print.

The above steps for jetting silver ink and reducing ink were repeated twice more on the same media to build up a second and third layer of silver on top of the first. Upon deposition of the second layer of silver, the printed pattern appeared more silvery and metallic. After deposition of the third layer, the printed pattern was "white silver" in color and had a smooth, mirror-like, reflective appearance.

### Conductivity Evaluation

Conductivity of the printed silver was evaluated by measuring resistance (lower resistance means better conductivity). Resistance was measured in one of two ways. One resistance measurement was obtained from a multimeter with the contacts positioned at opposite corners of the printed silver square. A second resistance measurement, the sheet resistance, was determined by the 4-point probe method of van der Pauw (Van der Pauw, L. J., Philips Technical Review 1958/1959, 26(8), 220-224.) Flash-dry™ conductive silver paint from SPI (Structure Probe, Inc., West Chester, PA) was used to add low-resistance electrical contacts, in the form of 1-2 mm diameter dots, to each corner of the printed silver square. The use of silver paint ensured that the contact resistance between the probes and the printed silver film was negligible. The multimeter resistance reading is referred to as the "two point" (2-pt) resistance and is reported in Ohms (Ω). The sheet resistance reading is referred to as the "four point" (4-pt) resistance and is reported in Ohms per square.

### Example 1

Silver ink 1A was printed with reducing ink 5A. Results, provided in the table below demonstrate that a highly conductive, smooth, mirror-like ("reflective") silver film was produced.

| Silver | Reducing | Appearance | Resistance | | Comments |
|---|---|---|---|---|---|
| Ink | Ink | | 2-pt | 4-pt | |
| 1A | 5A | Reflective silver | 0.8 | 0.352 | Smooth and mirror-like |

Optical and scanning electron microscopy (SEM) of the silver film showed smooth, uniform coverage of the patterned areas by silver metal. The metallic silver surface consisted of 200 nm-sized aggregates of 20 nm-sized silver particles.

### Example 2

The effect of reducing agent (formaldehyde) concentration and surfactant used in the reducing ink was tested by printing inks (5A, 5G, 5H, 5E, 5F and 51) with silver ink 1A. Inks set 1A/5A is a repeat run of the previous example.

The results, summarized in the following table, indicate that increasing formaldehyde ink concentration relative to silver ink concentration is detrimental to both the appearance and conductivity of the printed silver patterns. A 1.8 molar ratio of silver salt to reducing agent produced the best ink jet prints under the range of conditions explored. Also, ink with Zonyl® FS-62 gave less conductive prints than ink with Aerosol® OT or Surfynol® 465 surfactants. The Zonyl® ink (51) did not appear to wet the media surface as well as the other inks, therefore the drops did not overlap as well and a less uniform film was obtained.

| Silver Ink | Reducing Ink | Appearance | Resistance | | Comments |
|---|---|---|---|---|---|
| | | | 2-pt | 4-pt | |
| 1A | 5A | Reflective silver | ------ | 0.434 | 1.9 M HCOH; Surfynol |
| 1A | 5G | Reflective silver | 100 | 0.690 | 1.9 M HCOH; Aerosol |
| 1A | 5I | Reflective silver | 50,000 | 3.269 | 1.9 M HCOH; Zonyl |
| 1A | 5E | Less* reflective, darker silver | ------ | 0.801 | 3.8 M HCOH; Surfynol |
| 1A | 5H | Less reflective, darker silver | 5-100 | ------ | 3.8 M HCOH; Aerosol |
| 1A | 5F | Black, unreflective | Non- | conductive | 12.3 M HCOH; Aerosol |
| *Less reflective means somewhat reflective but not smooth and mirror-like | | | | | |

### Example 3

The silver concentration and the reducing agent concentration were increased (relative to inks 1A/5A in Example 1). The results, summarized in the following table, show that the ink set 1 B/5C in this example gave a significantly better sheet resistance than the 1A/5A ink set of Example 1. Higher concentration of silver is advantageous for deposition of a thicker, more conductive printed silver film for the same number of layers printed.

| Silver | Reducing | | Resistance | | |
|---|---|---|---|---|---|
| Ink | Ink | Appearance | 2-pt | 4-pt | Comments |
| 1 B | 5C | Reflective silver | ----- | 0.091 | 33 wt% silver |

### Example 4

Prints were made varying the number of layers of ink. Each "layer" consists of 100% area coverage of silver ink plus 100% area coverage of associated reducer ink. The results, summarized in the following table, show that increasing the number of printed layers provides a proportional improvement in conductivity

| Silver | Reducing | | Resistance | | Number |
|---|---|---|---|---|---|
| Ink | Ink | Appearance | 2-pt | 4-pt | of Layers |
| 1A | 5A | Black, unreflective | Non- | conductive | 1 |
| 1A | 5A | Reflective silver | ----- | 0.531 | 2 |
| 1A | 5A | Reflective silver | ----- | 0.274 | 3 |
| 1A | 5A | Reflective silver | ----- | 0.191 | 4 |

The amount of silver per unit area in each of these samples was also determined via quantitative silver analysis, using inductively coupled plasma (ICP). Each layer of silver printed was found to contribute 7.5 µg of silver per mm² to the printed silver film.

### Example 5

Silver ink was formulated with ethylamine and isopropylamine sensitizers. Tests and print results are summarized in the following table.

A print made with ethylamine ink 2A had sheet resistance that was substantially higher than that of comparable prints made with methylamine ink 1 A. The poor conductivity of this silver pattern was attributed to poor jetting, producing an inhomogeneous square with pronounced banding. To minimize the effect of banding on resistance, the paper was rotated 90° between layers so that layer 2 was printed perpendicularly to layers 1 and 3. This "bi-directional" printing yielded improved sheet conductivity.
Prints made with more concentrated ethylamine inks 2B (no surfactant) and 2C (0.1 wt% Aerosol-OT) had similar sheet resistances. Although these inks have higher silver concentration than 1B. they yield less conductive silver patterns. The silver patterns were homogeneous with little banding, so poor jetting did not appear to be the cause of the lower conductivity. Ink 3A was difficult to jet but was much more stable in storage than inks 1 and 2.

| Silver | Reducing | | Resistance | | |
|---|---|---|---|---|---|
| Ink | Ink | Appearance | 2-pt | 4-pt | Comments |
| 2A | 5B | Reflective silver | ----- | 6.01 | 30 wt% EtNH₂ |
| 2A | 5B | Reflective silver | ----- | 1.21 | "bi-directional" print |
| 2B | 5D | Reflective silver | ----- | 0.306 | 35 wt% EtNH₂ |
| 2C | 5D | Reflective silver | ----- | 0.376 | 35 wt% EtNH₂ |
| 3A | 5A | Reflective silver | ----- | 0.533 | 26 wt% i-PrNH₂ |

### Example 6

Various media and drying temperatures were tested. The results are summarized in the following table. On the default paper (HP Premium Photo Glossy Film), low temperature drying (22°C) yielded higher conductivity. On Epson Ink Jet Transparency media (C13S041064), higher (100°C) temperature yielded higher conductivity. The preferred drying temperature appears to be media dependent.

| Silver | Reducing | | Resistance | | Drying |
|---|---|---|---|---|---|
| Ink | Ink | Appearance | 2-pt | 4-pt | Temperature |
| 1A | 5A | Less reflective silver | Non- | conductive | 100°C |
| 1A | 5A | Reflective silver | ----- | 0.106 | 22°C |
| 1A | 5A | Reflective silver | ----- | 0.235 | 40°C |
| 1A | 5A | Less reflective silver | Non- | conductive | 100°C |
| 1A | 5A | Reflective silver | ----- | 2.127 | 55°C |
| 1A | 5A | Reflective silver | Non- | conductive | 55°C (Transparency) |
| 1A | 5A | Reflective silver | ----- | 0.634 | 100°C (Transparency) |

### Example 7

The print sequence was varied so that the silver ink and reducing ink were printed simultaneously or in reverse order with the reducing ink first and then the silver ink. To print simultaneously, the printer was programmed to print 100% coverage from the black pen (equipped with silver ink) and 100% coverage from the cyan pen (equipped with reducing ink) per pass of the printhead. This was done using a RIP file that bypassed the print driver (instead of Macromedia Freehand file previously described).

Tests and results are summarized in the following table. Standard sequential 1A/5A prints were made under the same conditions as the simultaneous 1A/5A prints (on the same day, with the same inks loaded into the printer, using the same type of RIP files) so that the two print sequences could be directly compared. Simultaneous deposition gives higher conductivity compared to standard sequential printing, but not the mirror-like appearance. The simultaneous print samples also appear to be less firmly adhered to the media.

Simultaneous deposition of the more concentrated inks 1 B and 5C also appeared to give highly conductive silver patterns as judged by the two point resistance of 11 ohm for a one-layer sample. Two- and 3-layer samples had resistances of 1 ohm and 0.5 ohm, respectively. However, severe banding caused by unreliable jetting of ink 1 B made it impossible to determine the 4-pt sheet resistance of any of these films, as the banding interrupted the conductive path.

Reverse order printing with ink 5A printed first, followed by Ink 1A yielded nonconducting patterns. Formaldehyde apparently evaporates so rapidly from the media after printing that it is no longer present by the time the silver ink is printed. For other, less volatile reducing agents the order of printing is not expected to influence the appearance or conductivity of printed silver films.

| Silver | Reducing | | Resistance | | |
|---|---|---|---|---|---|
| Ink | Ink | Appearance | 2-pt | 4-pt | Comments |
| 1A | 5A | Unreflective silver | ----- | 0.280 | 2-layer simultaneous |
| 1A | 5A | Unreflective silver | ----- | 0.100 | 3-layer simultaneous |
| 1A | 5A | Reflective silver | ----- | 2.67 | 2-layer sequential |
| 1A | 5A | Reflective silver | ----- | 1.05 | 3-layer sequential |
| 1B | 5C | Unreflective silver | 11 | ----- | 1-layer simultaneous |
| 1 B | 5C | Unreflective silver | 1 | ----- | 2-layer simultaneous |
| 1 B | 5C | Unreflective silver | 0.5 | ----- | 3-layer simultaneous |

### Example 8

Silver inks 1C-F with various organic additives were tested with formaldehyde reducing ink 5A or 5J. Results, summarized in the following table, show that prints on the standard HP media and an Epson Ink Jet transparency, with drying at 55°C, were non-conductive.

Examination of the above printed films by optical and scanning electron microscopy (SEM) revealed that the surfaces of the squares consisted of individual, poorly connected spots of silver, rather than a smooth, continuous film of silver. "Coffee ringing," a phenomenon in which ink solids dry in a ring around the edge of the deposited ink jet drop instead of uniformly over the surface of the drop, was also evident. Further formulation optimization is required to produce inks with favorable silver film forming characteristics.

| Silver | Reducing | | Resistance | | |
|---|---|---|---|---|---|
| Ink | Ink | Appearance | 2-pt | 4-pt | Comments |
| 1C | 5A | Less reflective | Non- | Conductive | 20 wt% methanol |
| 1 D | 5A | Less reflective | Non- | Conductive | 15 wt% 2-pyrrolidone |
| 1 E | 5A | Less reflective | Non- | Conductive | 5 wt% 2-pyrrolidone |
| 1 F | 5A | Less reflective | ----- | 420 | 5 wt% urea |
| 1A | 5J | Less reflective | Non- | Conductive | Formulated HCOH ink |
| 1 D | 5J | Less reflective | Non- | Conductive | 15 wt% 2-pyrrolidone, formulated HCOH |

### Example 9

Reducing agents other than formaldehyde were employed in combination with silver ink 1A. Glyoxal was the reducing agent in inks 6A-C, glycolaldehyde dimer was the reducing agent in inks 7A-B, DL-glyceraldehyde was the reducing agent in ink 8, glucose was the reducing agent in ink 9, and formic acid was the reducing agent in ink 10. Tests and results are summarized in the following table.

| Silver | Reducing | | Resistance | | |
|---|---|---|---|---|---|
| Ink | Ink | Appearance | 2-pt | 4-pt | Comments |
| 1A | 6A | Less reflective, darker silver | 1x10⁶ | ----- | 3.8 M glyoxal, Aerosol |
| 1A | 6B | Same as above | 1x10⁶ | ----- | 3.8 M glyoxal, Surfynol |
| 1A | 6C | Reflective silver | 1.3 | ----- | 1.9 M glyoxal, Surfynol |
| 1A | 7A | Dark brown unreflective | Non- | conduct. | 1.9 M glycolaldehyde dimer, Aerosol |
| 1A | 7B | Light gray, unreflective | Non- | conduct. | 1.9 M glycolaldehyde dimer, Surfynol |
| 1A | 8 | Dark gray unreflective | Non- | conduct. | 1.9 M glyceraldehyde, Surfynol |
| 1A | 9 | Black, sticky | Non- | conduct. | 1.9 M glucose |
| 1A | 10 | Black unreflective | Non- | conduct. | 1.9 M formic acid |

Silver patterns printed with 1.9 M glucose ink 9 appeared dark gray/black, and were neither reflective nor conductive. The printed films also adsorbed moisture from the air upon removal from the drying oven, forming sticky surface layers. This hygroscopic behavior suggests that a substantial residue of "oxidized glucose" organic byproducts were deposited on the surface of the printed silver film upon reduction of the silver salt by glucose. Such a residue was observed during spot tests and was washed away from silver films made on glass substrates using high-pressure water, without disturbing the silver film. However, silver films made on paper or plastic substrates could not be washed successfully without removing the silver film or destroying the substrate at the same time.

For all the reducing inks tested, preliminary spot tests resulted in rapid deposition of silver metal to form highly conductive, mirror-like silver films. Improved ink formulation and/or jetting conditions may be required to attain printed patterns with the performance levels predicted by the spot test results.

### Example 10 (Comparative)

Amine-free silver inks 4A-B were printed in combination with reducing inks containing TMEDA (Inks 11A-B) or TEEDA (Ink 12) as summarized in the following table. In all cases, dark brown/black, non-conductive prints were obtained.

Ink 4A was difficult to jet, but ink 4B (formulated with 25 wt% ethylene glycol) jetted well. Both inks, however, produced non-conductive prints, suggesting that jetting behavior alone was not responsible for poor conductivity. Examination of the prints by optical microscopy showed that colorless crystals of silver nitrate were present on the surface of the printed patterns, indicating that most of the silver ion in the ink was not reduced to metal by the reducing ink. Apparently, under these conditions, the rate of reduction of silver salt is slower than the evaporation rate of the reducer.

| Silver | Reducing | | Resistance | | |
|---|---|---|---|---|---|
| Ink | Ink | Appearance | 2-pt | 4-pt | Comments |
| 4A | 11A | Dark brown/black | Non- | conductive | 5MAgNO₃, 2.5MTMEDA |
| 4A | 12 | Dark brown/black | Non- | conductive | 5 M AgNO₃, 1.7 M TEEDA |
| 4B | 11 B | Dark brown/black | Non- | conductive | 3.3 M AgNO₃ with ethylene glycol; 1.5 M TMEDA |

### Example 11

A drum printer with two fixed printheads was used to print a pattern of narrow parallel lines using Inks 1A and 5A. The printing apparatus consisted of two Epson 3000 piezoelectric ink-jet printheads mounted in fixed position above a rotating drum (circumference 28.375 inches) to which the substrate was attached. The two printheads were aligned to print on the same area of the substrate and the gap between them was small so that when fired together, the silver ink and reducing ink were effectively printed simultaneously. The firing frequency was 14.4 kHz and the drum speed was adjusted to give a linear speed of 5 inches/second past the printhead, unless otherwise noted. The weight of a drop of silver ink 1A was measured by jetting a known number of drops onto an electronic balance, and found to be 28 ng.

The test pattern in this case was a series of three parallel lines, each line generated by the firing of one nozzle on the print head containing the silver ink and the comparable nozzle on the print head containing the reducer ink. The three nozzles used were spaced apart so that the three lines remained distinct. The other nozzles were not fired. Lines were separately generated with four, six, eight or ten layers of silver. Two different firing modes were used. In one mode (simultaneous mode) inks 1A and 5A were jetted simultaneously. In the other mode (sequential mode), the silver ink 1A was printed (all 4, 6, 8 or 10 layers) and then the reducer ink 5A was printed (all 4, 6, 8, or 10 layers).

The sheet resistance of each line was measured in three places using a 4-point probe method, and reported as the averaged value. The reported line width was an average of three points measured with a calibrated optical microscope. Results are summarized in the following table. All of the lines printed appeared metallic and reflective, although lines with the least silver coverage per unit area were narrower and sometimes discontinuous, and thus not conductive.

| Silver Ink | Reducing Ink | Number Layers | µg Ag/ cm | Speed (inch/sec) | Deposition Mode | Width (µm) | Resist. 4-pt |
|---|---|---|---|---|---|---|---|
| 1A | 5A | 4 | 34 | 5 | sequential | 254 | 0.208 |
| 1A | 5A | 4 | 34 | 5 | simultaneous | 253 | 0.141 |
| 1A | 5A | 6 | 51 | 5 | sequential | 262 | 0.091 |
| 1A | 5A | 6 | 51 | 5 | simultaneous | 259 | 0.046 |
| 1A | 5A | 8 | 68 | 5 | sequential | 268 | 0.081 |
| 1A | 5A | 8 | 68 | 5 | simultaneous | 277 | 0.026 |
| 1A | 5A | 10 | 85 | 5 | sequential | 270 | 0.063 |
| 1A | 5A | 10 | 85 | 5 | simultaneous | 248 | 0.023 |
| 1A | 5A | 10 | 17 | 25 | simultaneous | 97 | 0.116 |

The same trends seen for silver squares printed on the Epson 3000 were also observed for these printed silver lines. In one test, the drum speed was increased so that the linear feed rate past the printhead was 25 inches/sec. The higher speed (without changing the firing frequency) caused less ink to be deposited per pass and gave a narrower line width. Lines generated in simultaneous mode were more conductive than the comparable lines printed in sequential mode.

## Claims

1. An inkjet ink set comprising a first inkjet ink comprising aqueous vehicle having dissolved therein a silver salt and an amine sensitizer for the silver salt, wherein the amine sensitizer is a compound containing at least one amine group, and wherein the first ink contains at least about 1% by weight silver ion (Ag⁺¹) based on the total weight of the first ink, and a second inkjet ink that comprises a reducing agent capable of reducing silver salt to silver metal.

2. The inkjet ink set of claim 1, **characterized in that** the first ink contains from about 10 wt% to about 40 wt% silver ion (Ag¹⁺) based on the total weight of first ink.

3. The inkjet ink set of claim 1, **characterized in that** the amine sensitizer is present in the first ink at levels of at least about 1% by weight based on the total weight of first ink.

4. The inkjet ink set of claim 1, **characterized in that** amine sensitizer is present in the first ink in a molar ratio of at least about 2 moles of amino groups per mole of silver.

5. The inkjet ink set of claim 1, **characterized in that** the amine sensitizer is a compounds of the formula 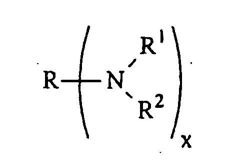 wherein R is an organic group having 1-3 carbon atoms; R¹ is H or methyl, R² is H or methyl, and x is an integer of from 1 to 3.

6. The inkjet ink set of claim 1, **characterized in that** the surface tension of the inks is from about 20 to about 50 dyne/cm.

7. The inkjet ink set of any one of claims 1-6, **characterized in that** the first ink is substantially clear and colorless.

8. The inkjet ink set of any of claims 1 to 7, wherein the reducing agent in the second ink is selected from the group consisting of formaldehyde, glyoxal, formic acid, glyceraldehyde, glycolaldehyde dimer and mixtures thereof.

9. A method for ink jet printing a silver pattern or image onto a substrate, comprising the steps of:
(a) providing an ink jet printer that is responsive to digital data signals;
(b) loading the printer with a substrate to be printed;
(c) loading the printer with an inkjet ink set as set forth in any one of claims 1-8;
(d) ejecting the inkjet ink onto the substrate in response to the digital data signals to print an image or pattern of the silver salt on the substrate; and
(e) concurrently with or subsequent to the ejecting step, effecting reduction of at least a portion of the silver salt in the image or pattern on the substrate to silver metal to produce the silver image or pattern,
wherein the reduction is effected at least in part by the reducing agent in the second inkjet ink.

## Patentansprüche

1. Tintenstrahltintensatz mit einer ersten Tintenstrahltinte, die eine wäßrige Trägerflüssigkeit mit einem darin gelösten Silbersalz und einem Aminsensibilisator für das Silbersalz aufweist, wobei der Aminsensibilisator eine Verbindung ist, die mindestens eine Amingruppe enthält, und wobei die erste Tinte mindestens etwa 1 Gew.-% Silberionen (Ag⁺¹) enthält, bezogen auf das Gesamtgewicht der ersten Tinte, und mit einer zweiten Tintenstrahltinte, die ein Reduktionsmittel aufweist, das Silbersalz zu metallischem Silber reduzieren kann.

2. Tintenstrahltintensatz nach Anspruch 1, **dadurch gekennzeichnet, daß** die erste Tinte etwa 10 Gew.-% bis etwa 40 Gew.-% Silberionen (Ag⁺¹) enthält, bezogen auf das Gesamtgewicht der ersten Tinte.

3. Tintenstrahltintensatz nach Anspruch 1, **dadurch gekennzeichnet, daß** der Aminsensibilisator in Anteilen von mindestens etwa 1 Gew.-% anwesend ist, bezogen auf das Gesamtgewicht der ersten Tinte.

4. Tintenstrahltintensatz nach Anspruch 1, **dadurch gekennzeichnet, daß** der Aminsensibilisator in der ersten Tinte in einem Molverhältnis von mindestens etwa 2 Mol Amingruppen pro Mol Silber anwesend ist.

5. Tintenstrahltintensatz nach Anspruch 1, **dadurch gekennzeichnet, daß** der Aminsensibilisator eine Verbindung mit der Formel 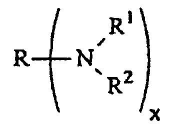 ist, wobei R eine organische Gruppe mit 1-3 Kohlenstoffatomen ist; R¹ für H oder Methyl steht, R² für H oder Methyl steht und x eine ganze Zahl von 1 bis 3 ist.

6. Tintenstrahltintensatz nach Anspruch 1, **dadurch gekennzeichnet, daß** die Oberflächenspannung der Tinten etwa 20 bis etwa 50 dyn/cm beträgt.

7. Tintenstrahltintensatz nach einem der Ansprüche 1-6, **dadurch gekennzeichnet, daß** die erste Tinte im wesentlichen klar und farblos ist.

8. Tintenstrahltintensatz nach einem der Ansprüche 1-7, wobei das Reduktionsmittel in der zweiten Tinte aus der Gruppe ausgewählt ist, die aus Formaldehyd, Glyoxal, Ameisensäure, Glycerinaldehyd, Glycolaldehyd-Dimer und Gemischen davon besteht.

9. Verfahren zum Tintenstrahldruck eines Silbermusters oder -bilds auf ein Substrat mit den folgenden Schritten:
(a) Bereitstellen eines Tintenstrahldruckers, der auf digitale Datensignale anspricht;
(b) Laden des Druckers mit einem zu bedruckenden Substrat;
(c) Laden des Druckers mit einem Tintenstrahltintensatz, wie in einem der Ansprüche 1-8 dargelegt;
(d) Ausspritzen der Tintenstrahltinte auf das Substrat als Reaktion auf die digitalen Datensignale, um ein Bild oder Muster aus dem Silbersalz auf dem Substrat zu drucken; und
(e) gleichzeitig mit dem oder anschließend an den Ausspritzschritt, Bewirken der Reduktion zumindest eines Teils des Silbersalzes in dem Bild oder Muster auf dem Substrat zu metallischem Silber, um das Silberbild oder-muster zu erzeugen,
wobei die Reduktion zumindest teilweise durch das Reduktionsmittel in der zweiten Tintenstrahltinte bewirkt wird.

## Revendications

1. Jeu d'encres d'impression par jet d'encre comprenant une première encre d'impression par jet d'encre comprenant un véhicule aqueux possédant dissous dans celui-ci un sel d'argent et un sensibilisateur d'amine pour le sel d'argent, dans lequel le sensibilisateur d'amine est un composé contenant au moins un groupe amine et dans lequel la première encre contient au moins environ 1% en poids d'ion argent (Ag⁺¹) sur la base du poids total de la première encre, et une deuxième encre d'impression par jet d'encre qui comprend un agent réducteur capable de réduire le sel d'argent en argent métallique.

2. Jeu d'encres d'impression par jet d'encre selon la revendication 1, **caractérisé en ce que** la première encre contient d'environ 10% en poids à environ 40% en poids d'ion argent (Ag⁺¹) sur la base du poids total de la première encre.

3. Jeu d'encres d'impression par jet d'encre selon la revendication 1, **caractérisé en ce que** le sensibilisateur d'amine est présent dans la première encre à des niveaux d'au moins environ 1% en poids sur la base du poids total de la première encre.

4. Jeu d'encres d'impression par jet d'encre selon la revendication 1, **caractérisé en ce que** le sensibilisateur d'amine est présent dans la première encre dans un rapport molaire d'au moins environ 2 moles de groupes amino par mole d'argent.

5. Jeu d'encres d'impression par jet d'encre selon la revendication 1, **caractérisé en ce que** le sensibilisateur d'amine est un composé de la formule: 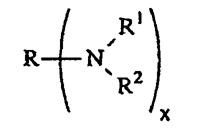 dans laquelle R est un groupe organique possédant 1-3 atomes de carbone; R¹ est H ou un méthyle, R² est H ou un méthyle, et x est un nombre entier de 1 à 3.

6. Jeu d'encres d'impression par jet d'encre selon la revendication 1, **caractérisé en ce que** la tension de surface des encres est d'environ 20 à environ 50 dynes/cm.

7. Jeu d'encres d'impression par jet d'encre selon l'une quelconque des revendications 1-6, **caractérisé en ce que** la première encre est substantiellement claire et incolore.

8. Jeu d'encres d'impression par jet d'encre selon l'une quelconque des revendications 1 à 7, dans lequel l'agent réducteur dans la deuxième encre est choisi dans le groupe constitué de formaldéhyde, de glyoxal, d'acide formique, de glycéraldéhyde, de dimère de glycolaldéhyde et de mélanges de ceux-ci.

9. Procédé pour l'impression par jet d'encre d'un motif ou d'une image d'argent sur un substrat, comprenant les étapes:
(a) de fourniture d'une imprimante à jet d'encre qui est réceptive à des signaux de données numériques;
(b) de chargement de l'imprimante avec un substrat à imprimer;
(c) de chargement de l'imprimante avec un jeu d'encres d'impression par jet d'encre selon l'une quelconque des revendications 1-8;
(d) de projection de l'encre d'impression par jet d'encre sur le substrat en réponse aux signaux de données numériques pour imprimer une image ou un motif du sel d'argent sur le substrat; et
(e) simultanément ou ultérieurement à l'étape de projection, de réalisation de la réduction d'au moins une portion du sel d'argent dans l'image ou le motif sur le substrat en argent métallique pour produire l'image ou le motif d'argent,
dans lequel la réduction est réalisée au moins en partie par l'agent réducteur dans la deuxième encre d'impression par jet d'encre.
